(19) **Europäisches Patentamt**
**European Patent Office**
**Office européen des brevets**

(11) **EP 3 653 991 B1**

(12) **EUROPÄISCHE PATENTSCHRIFT**

(45) Veröffentlichungstag und Bekanntmachung des Hinweises auf die Patenterteilung:
**10.11.2021 Patentblatt 2021/45**

(51) Int Cl.:
***G01C 19/5776*** *(2012.01)*

(21) Anmeldenummer: **19208221.2**

(22) Anmeldetag: **11.11.2019**

(54) **VERFAHREN UND SIGNALVERARBEITUNGSVORRICHTUNG ZUR AUTOMATISCHEN FREQUENZANPASSUNG EINES FILTERS IN EINER GESCHLOSSENEN REGELSCHLEIFE**

METHOD AND SIGNAL PROCESSING DEVICE FOR AUTOMATICALLY ADJUSTING THE FREQUENCY OF A FILTER IN A CLOSED CONTROL LOOP

PROCÉDÉ ET DISPOSITIF DE TRAITEMENT DE SIGNAL D'ADAPTATION AUTOMATIQUE DE LA FRÉQUENCE D'UN FILTRE DANS UNE BOUCLE DE RÉGULATION FERMÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.11.2018 DE 102018219333**

(43) Veröffentlichungstag der Anmeldung:
**20.05.2020 Patentblatt 2020/21**

(73) Patentinhaber: **Albert-Ludwigs-Universität Freiburg**
**79098 Freiburg (DE)**

(72) Erfinder:
• **MARX, Maximilian**
**79104 Freiburg (DE)**
• **DE DORIGO, Daniel**
**79106 Freiburg (DE)**
• **MANOLI, Yiannos**
**79104 Freiburg (DE)**
• **CUIGNET, Xavier**
**79114 Freiburg (DE)**

(74) Vertreter: **Grünecker Patent- und Rechtsanwälte PartG mbB**
**Leopoldstraße 4**
**80802 München (DE)**

(56) Entgegenhaltungen:
**EP-A1- 3 222 968**

• HUANZHANG HUANG ET AL: "Frequency and Q tuning techniques for continuoustime bandpass sigma-delta modulator", IEEE INTERNATIONAL SYMPOSIUM ON CIRCUITS AND SYSTEMS, 2002. ISCAS 2002,, Bd. 5, 7. August 2002 (2002-08-07), Seiten V-589, XP002772414, DOI: 10.1109/ISCAS.2002.1010772 ISBN: 978-0-7803-7448-5
• AFIFI M ET AL: "An automatic tuning technique for background frequency calibration in gyroscope interfaces based on high order bandpass Delta-Sigma modulators", 2015 IEEE INTERNATIONAL SYMPOSIUM ON CIRCUITS AND SYSTEMS (ISCAS), IEEE, 24. Mai 2015 (2015-05-24), Seiten 1730-1733, XP033183472, DOI: 10.1109/ISCAS.2015.7168987 [gefunden am 2015-07-27]

**Beschreibung**

Die vorliegende Erfindung bezieht sich auf ein Verfahren zur automatischen Frequenzanpassung eines Filters während des Betriebs in einer geschlossenen Regelschleife und insbesondere zur automatischen Frequenzanpassung einer mikromechanischen Drehratensensors während des Betriebs. Ein solcher Drehratensensor findet beispielsweise in Fahrerassistenzsystemen, Navigationssystemen und zunehmend in mobilen batteriebetriebenen Geräten wie Smartphones oder Tablet-Computern Anwendung. Während die Erfindung allgemein für die Anpassung jeglicher Filter Verwendung finden kann, bei der eine breitbandige Anregung der Filter erfolgt und anhand eines der Signale in der Anwendung eine Transferfunktion der Filter näherungsweise abgebildet wird, und die Erfindung für Analog-Digital-Wandler mit geschlossenen Regelschleifen, beispielsweise Delta-Sigma-Modulator-Analog-Digital-Wandler, Verwendung finden kann, wird im weiteren die Verwendung für Drehratensensor im Detail betrachtet. Andere Sensoren, für die die Erfindung Verwendung finden kann, umfassen beispielsweise Lorentzkraft-Magnetfeldsensoren.

Mikroelektromechanische (MEM) Coriolis-Drehratensensoren (engl. Coriolis Vibratory Gyroscope, CVG) besitzen eine bewegliche mechanische Struktur, welche zu einer periodischen Schwingung angeregt wird. Diese periodische, durch Anregung erzeugte Schwingung wird auch als primäre Schwingung bezeichnet. Erfährt der Sensor eine Drehung um eine Achse senkrecht zu der Primärschwingung oder Primärbewegung, so führt die Bewegung der Primärschwingung zu einer Corioliskraft, die proportional zur Messgröße, d. h. der Winkelgeschwindigkeit, ist. Diese Achse wird als die sensitive Achse des Sensors bezeichnet. Durch die Corioliskraft wird eine zweite, zur Primärschwingung orthogonale Schwingung angeregt. Diese zweite, zur Primärschwingung orthogonale Schwingung wird auch als Sekundärschwingung oder Sekundärbewegung bezeichnet. Die Sekundärschwingung, die auch als Detektionsschwingung bezeichnet wird, kann durch verschiedene Messverfahren erfasst werden, wobei die erfasste Größe als Maß für die auf den Drehratensensor wirkende Drehrate dient. Um die Primärschwingung zu erzeugen, werden unter anderem thermische, piezoelektrische, elektrostatische und induktive Verfahren verwendet, welche in der Technik bekannt sind. Zu der Erfassung der Sekundärschwingung sind piezoelektrische, piezoresistive oder kapazitive Prinzipien Stand der Technik.

Drehratensensoren detektieren Drehraten um eine definierte sensitive Achse basierend auf dem Coriolis-Effekt. Der Drehratensensor umfasst eine primäre und eine sekundäre Masse. Um eine Drehrate mit Hilfe des Coriolis-Effekts detektieren zu können, muss die gesamte Masse in Bewegung versetzt werden. Die primäre Masse, in der die sekundäre Masse aufgehängt ist, wird beispielsweise durch eine elektrostatische Aktuierung mit ihrer Resonanzfrequenz in eine konstante Schwingung versetzt. Durch eine Rotation des Sensors um die sensitive Achse wirkt auf die sekundäre Masse orthogonal zur primären Achse gemäß der nachfolgenden Gleichung (1) die Coriolis Kraft $F_c$ so, dass die sekundäre Masse ausgelenkt wird.

$$\vec{F}_c = -2m\vec{\Omega} \times \vec{v}_p \tag{1}$$

Dabei ist m die sekundäre Masse, $\Omega$ die Drehrate und $v_p$ die Geschwindigkeit der primären Masse. Die sekundäre Masse ist idealerweise mechanisch so aufgehängt, dass sie nur orthogonal zur primären Oszillation auslenken kann. Eine große Amplitude der Primärschwingung ist wünschenswert, um eine hohe Empfindlichkeit zu erreichen. Die Primärmasse wird hierbei üblicherweise resonant angeregt und die Amplitude der Schwingung mittels einer automatischen Verstärkungsregelung (Automatic Gain Control, AGC) geregelt, wie dies aus dem Artikel T. Northemann, M. Maurer, S. Rombach, A. Buhmann, Y. Manoli: "Drive and sense interface for gyroscopes based on bandpass sigma-delta modulators", Proc. IEEE Int. Circuits and Systems (ISCAS) Symp, pages 3264-3267, 2010, bekannt ist.

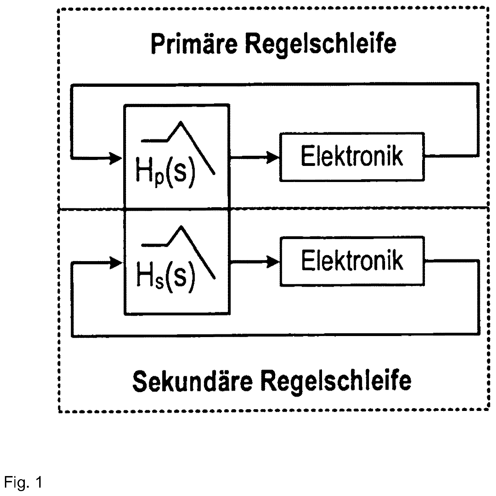

Figur 1 zeigt schematisch einen Drehratensensor mit einer primären Regelschleife für den Antrieb und einer sekundären Regelschleife für das Auslesen des Signals. Um eine hohe Linearität, große Bandbreiten und eine verringerte Empfindlichkeit gegenüber Prozessschwankungen zu erreichen, werden diese Sensoren, wie in Figur 1 zu sehen, sowohl auf der primären als auch auf der sekundären Seite rückgekoppelt betrieben. In der sekundären Regelschleife wird gemäß der nachfolgenden Gleichung (2) durch das Aufbringen einer rückstellenden kapazitiven Kraft die wirkende Coriolis Kraft $\vec{F}_C$ kompensiert:

$$\vec{F}_C = \vec{F}_{es} \tag{2}$$

Dadurch bleibt die sekundäre Masse in der Ruheposition und die generierte Kraft $\vec{F}_{es}$ bildet ein direktes Maß für die auf das System einwirkende Drehrate.

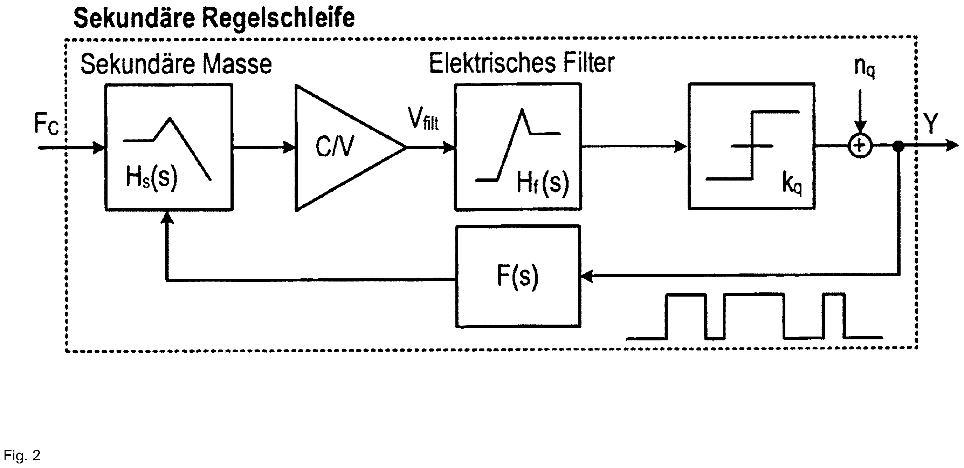

Das erforderliche Kompensationssignal wird üblicherweise durch die Einbettung des Sensors in eine geschlossene Regelschleife eines Delta-Sigma-Modulators (nachfolgend auch abgekürzt als ΔΣM) erzeugt. Figur 2 zeigt schematisch ein vereinfachtes Blockschaltbild einer sekundären Regelschleife zum Betrieb eines Drehratensensors basierend auf der Delta-Sigma-Modulation. Auf diese Weise wird das Ausgangssignal direkt hochauflösend digitalisiert und es wird eine hohe Linearität erreicht.

$\Delta\Sigma$M basieren unter anderem auf einer Rauschformung. Dabei wird das am Ausgang entstehende Quantisierungsrauschen $n_q$ durch Filter, die innerhalb des Modulators vorgesehen sind, im Signalband unterdrückt und zu anderen Frequenzen hin verschoben. Bei der Realisierung eines elektromechanischen $\Delta\Sigma$M wird häufig neben dem eigentlichen mechanischen Sensorelement $H_s(s)$, das als ein mechanisches Filter verstanden werden kann, auch ein zusätzliches elektronisches Filter für die Rauschformung genutzt, wie es ebenfalls in Figur 2 gezeigt ist. Dieses Filter $H_f(s)$ ist typischerweise als Bandpassfilter ausgelegt. Daraus ergeben sich die Rausch-Transferfunktion (NTF) entsprechend der nachfolgenden Gleichung (3) und die Signal-Transferfunktion (STF) nach Gleichung (4).

$$NTF = \frac{Y}{n_q} = \frac{1}{1+F(s)k_q H_s(s)H_f(s)} \tag{3}$$

$$STF = \frac{Y}{F_C} = \frac{k_q H_s(s)H_f(s)}{1+F(s)k_q H_s(s)H_f(s)} \approx \frac{1}{F(s)} \tag{4}$$

Dabei bedeuten Y das Ausgangssignal des $\Delta\Sigma$M, $k_q$ eine Quantisierungskonstante, F(s) die Übertragungsfunktion der Rückkopplung, $H_f(s)$ die Übertragungsfunktion des elektrischen Filters, $H_s(s)$ die Übertragungsfunktion der sekundären Masse.

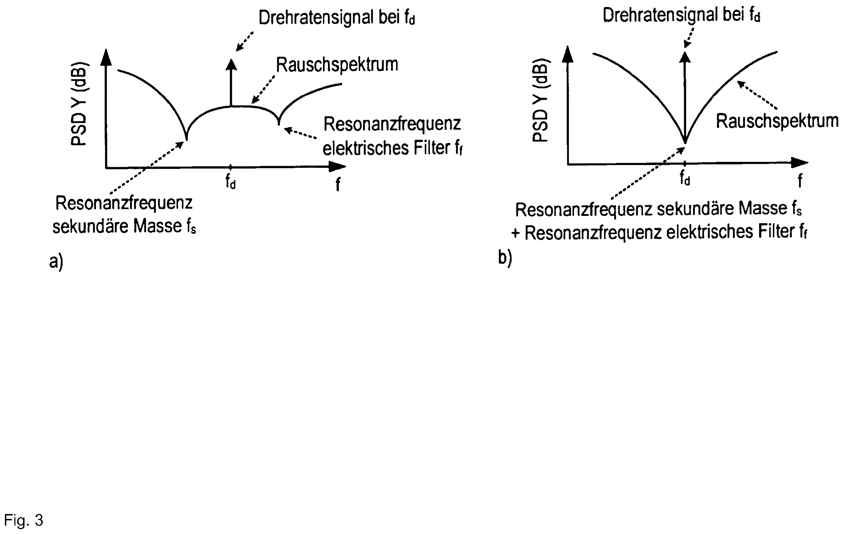

Um das bestmögliche Signal-zu-Rauschverhältnis (SNR) und eine hohe Stabilität des Arbeitspunkts zu erreichen, müssen die Resonanzfrequenz $f_s$ der sekundären Masse (sekundäre Resonanzfrequenz) und die Resonanzfrequenz $f_f$ des elektrischen Filters $H_f(s)$ sehr genau mit der primären Resonanzfrequenz des Drehratensensors $f_d$, auf der das Drehratensignal moduliert ist, übereinstimmen. Das typische Leistungsspektrum des Ausgangs Y eines $\Delta\Sigma$M ist in den Figuren 3a und 3b für die Fälle, dass die Frequenzen $f_d$, $f_s$ und $f_f$ nicht übereinstimmen (Figur 3a) bzw. übereinstimmen (Figur 3b) dargestellt. Das SNR ist im Fall übereinstimmender Frequenzen deutlicher höher.

Es stellt sich also die Aufgabe, die sekundäre Resonanzfrequenz $f_s$ anzupassen. Dies ist notwendig, da sich große Schwankungen der Resonanzfrequenz $f_s$ der sekundären Massen bei der Herstellung des Sensors und im Betrieb unter dem Einfluss von Temperaturänderungen ergeben. Hinzu kommt, dass die primäre Resonanzfrequenz von Drehratensensoren $f_d$ ebenfalls stark variieren kann. Diese Schwankungen führen dazu, dass die Sensorausleseschaltungen zum einen anfänglich eingestellt werden muss, und zum anderen Schwankungen während des Betriebs ausgeglichen werden müssen.

Im Stand der Technik sind verschiedene Konzepte zur Anpassung der Resonanzfrequenz $f_f$ des elektrischen Filters bekannt (siehe DE 10 2016 204683 und Referenzen darin).

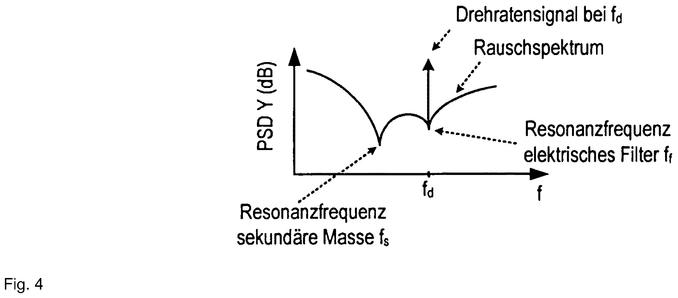

Im Folgenden wird davon ausgegangen, dass die Resonanzfrequenz $f_f$ des elektrischen Filters beispielsweise mit Hilfe des in der DE 10 2016 204683 beschriebenen Verfahrens bereits auf die primäre Resonanzfrequenz $f_d$ des Drehratensensors angepasst wurde. Somit ergibt sich ein typisches Leistungsspektrum des Ausgangs Y des elektromechanischen $\Delta\Sigma$M, wie es in Figur 4 dargestellt ist, in dem die Frequenz $f_s$ zu tief liegt.

Um eine Verringerung des SNR zu vermeiden, muss die Einstellung der Frequenz $f_s$ der sekundären Masse sehr genau sein. So sollte der Fehler zwischen der primären $f_d$ und sekundären $f_s$ Sensorresonanzfrequenz geringer als die Bandbreite BW des Drehratensignals sein. Aus typischen Werten für die Bandbreite $BW = 50$ Hz und die primäre Sensorresonanzfrequenz $f_d = 10$ kHz ergibt sich beispielsweise eine hohe geforderte relative Genauigkeit von 0.5%. In Bezug auf die Stabilität des Arbeitspunkts und somit des Nullpunktfehlers des Sensors, können sich zudem noch höhere Anforderungen im Bereich von weniger als 0.1% $f_d$ ergeben.

Prinzipiell kann die Resonanzfrequenz $f_s$ des sekundären Resonators des Drehratensensors mittels des sogenannten "Spring-Softening" Effekts eingestellt werden. Hierfür weist der Sensor spezielle Kapazitäten auf. Wird eine Spannung $V_f$ an diese Kapazitäten angelegt, bewirkt der nichtlineare Zusammenhang zwischen Spannung und elektrostatischer Kraft unter anderem eine Kraft-Komponente, welche linear mit der Auslenkung der sekundären Masse skaliert. Da dieser Zusammenhang äquivalent zu einer mechanischen Federkonstante $k_{mech}$ ist, wird von einer zusätzlichen elektrostatischen Federkraft $k_{el}$ gesprochen. Die effektive Federkonstante $k_{eff} = k_{meeh} - k_{el} \sim k_{mech} - V_f^2$ und somit die Resonanzfrequenz $f_s = (k_{eff}/m)^{1/2}$ der sekundären Masse m verringern sich mit Erhöhung der angelegten Spannung $V_f$.

Im Stand der Technik sind Verfahren zur Anpassung der sekundären Resonanzfrequenz eines Drehratensensors, wenn dieser nicht beziehungsweise nicht vollständig in einer geschlossenen Regelschleife betrieben wird, bekannt. So wird in einem Artikel von A. Sharma, M. F. Zaman und F. Ayazi, "A sub-0.2°/hr bias drift micromechanical silicon gyroscope with automatic CMOS modematching", IEEE J. Solid-State Circuits, Bd. 44, Nr. 5, S. 1593-1608, Mai 2009, und einem Artikel von S. Sonmezoglu, S. E. Alper und T. Akin, "An Automatically Mode-Matched MEMS Gyroscope With Wide and Tunable Bandwidth", Journal of Microelectromechanical Systems, Bd. 23, Nr. 2, S. 284-297, April 2014, ein Verfahren basierend auf der Maximierung eines Offset-Signals des Drehratensensors beschrieben.

Gemäß der Lehre in S. Sung, W. T. Sung, C. Kim, S. Yun and Y. J. Lee, "On the Mode-Matched Control of MEMS Vibratory Gyroscope via Phase-Domain Analysis and Design", IEEE/ASME Transactions on Mechatronics, Bd. 14, Nr. 4, S. 446-455, August 2009, wird die sekundäre Masse des Sensors mit der Resonanzfrequenz der primären Masse aktiv angeregt und der sich daraus ergebende Phasenunterschied als Messgröße für die Resonanzfrequenz der sekundären Masse genutzt. Auch in der C. He et al., "A MEMS Vibratory Gyroscope With Real-Time Mode-Matching and Robust Control for the Sense Mode", IEEE Sensors Journal, Bd. 15, Nr. 4, S. 2069-2077, April 2015, wird beschrieben, die sekundäre Masse außerhalb der geschlossenen Schleife anzuregen, um somit die Frequenzantwort zu charakterisieren. Ein Einsatz während des Betriebs des Sensors in geschlossenen Regelschleifen und somit das kontinuierliche Anpassen der Resonanzfrequenzen, beispielsweise unter Einfluss von Temperaturänderungen, ist gemäß diesen Ansätzen nicht möglich.

In Huanzhang Huang; Lee, E.K.F., "Frequency and Q tuning techniques for continuoustime bandpass sigma-delta modulator", ISCAS 2002. IEEE International Symposium on Circuits and Systems, Bd.5, Nr., S.V-589 - V-592, 2002, wird das Prinzip einer Schaltung zur Frequenzanpassung eines elektrischen Filters in einem rein elektrischen $\Delta\Sigma$M beschrieben. Es werden zwei unterschiedliche Ansätze zur Bestimmung der Rauschleistung am Ausgang des Modulators an zwei diskreten Punkten $f_a$ beziehungsweise $f_b$, die oberbeziehungsweise unterhalb der eigentlichen Signalfrequenz um $f_d$ herum liegen, vorgestellt. Da das elektrische Filter die Rauschleistung an diesen diskreten Frequenzen in Abhängigkeit der Lage seiner Resonanzfrequenz unterschiedlich beeinflusst, kann durch den Betrag der beiden Rauschleistungen bestimmt werden, ob die Filterresonanzfrequenz zu hoch oder zu niedrig ist. Die Lehre beschränkt sich auf die Anpassung der Frequenz elektrischer Filter und die Regelung erfolgt relativ langsam und ungenau bei einem hohen Flächenbedarf für die Implementierung.

Weitere Verfahren zur Bestimmung der sekundären Resonanzfrequenz verwenden Testsignale, die nach dem sekundären Resonator in die Regelschleife eingespeist werden (siehe beispielsweise Yun-Shiang Shu; Bang-Sup Song; Bacrania, K., "A 65nm CMOS CT $\Delta\Sigma$ Modulator with 81 dB DR and 8MHz BW Auto-Tuned by Pulse Injection", Solid-State Circuits Conference, 2008. ISSCC 2008. Digest of Technical Papers, IEEE International, S. 500 - 631, 3.-7. Februar 2008; Michael Maurer, Stefan Rombach, Yiannos Manoli, "Resonance Frequency Control and Digital Correction for Capacitive MEMS Gyroscopes within electromechanical Bandpass Delta-Sigma-Modulators", 2018 IEEE International Symposium on Inertial Sensors and Systems (INERTIAL), S. 61-64; DE 199 10415 A1, US2018/0128674 A1 und EP2 466 257 A1). Dadurch kann die Resonanzfrequenz der sekundären Masse $f_s$ eingestellt werden, indem geprüft wird wie das Testsignal von der Transferfunktion am digitalen Ausgang des Modulators unterdrückt wird. Je nach Phasenlage und Größe des verbleibenden Testsignals am Ausgang kann darauf rückgeschlossen werden, ob die Resonanzfrequenz $f_s$ zu hoch oder zu niedrig liegt. Ein digitaler Regler steuert dementsprechend die sekundäre Resonanzfrequenz $f_s$ des Sensors über elektrostatische Aktoren am Sensor nach. Nachteilig ist der erhöhte Flächenbedarf für die Auswertung der Testsignale und je nach Implementierung ein bedeutender zusätzlicher Bedarf an Fläche für die Generierung der Testsignale und die Einspeisung in die Ausleseschleife. Die Testsignale müssen zudem genau und rauscharm generiert beziehungsweise in die Ausleseschleife eingespeist werden, um diese nicht zu stören.

Mit Hinblick auf obige Diskussion liegt der vorliegenden Erfindung unter anderem (namentlich im Zusammenhang mit der Resonanzanpassung von Drehratensensoren; allgemeiner besteht die Aufgabe darin, die Frequenz eines dem elektrischen Filter $H_f$ vorgeschalteten Filters anzupassen) die Aufgabe zugrunde, die Resonanzfrequenz $f_s$ der sekundären Masse automatisch und im Betrieb auf die primäre Resonanzfrequenz $f_d$ des Drehratensensors anzupassen. Diese Aufgabe wird durch Bereitstellen eines Verfahrens nach Patentanspruch 1 und einer Vorrichtung gemäß Patentanspruch 6 gelöst. Das bereitgestellte Verfahren basiert auf der Bewertung der Rauschformung der geschlossenen Regelschleife am Ausgang des $\Delta\Sigma$M in einem differentiellen Band um die primäre Resonanzfrequenz $f_d$ herum. Das Rauschspektrum des Ausgangssignals der geschlossenen Regelschleife wird für zwei symmetrisch zu etwa der primären Resonanzfrequenz als vorgegebenen Frequenzwert bestimmten Frequenzbändern ermittelt, und es erfolgt eine Frequenzanpassung basierend auf einer ermittelten Differenz in den Rauschspektren.

Es wird also ein Verfahren zur Anpassung der Resonanzfrequenz eines ersten Filters einer geschlossenen Regelschleife, die einen Delta-Sigma-Modulator umfasst, an eine vorgegebene Frequenz (insbesondere die Resonanzfrequenz eines weiteren Filters oder mechanischen Resonators), bereitgestellt, wobei das Verfahren die folgenden Schritte aufweist:

Zuführen eines Ausgangssignals des Delta-Sigma-Modulators (und somit der geschlossenen Regelschleife) in eine Frequenzanpassungsschaltung,
Ermitteln eines ersten Rauschspektrums des Ausgangssignals des Delta-Sigma-Modulators für ein erstes Frequenzband und eines zweiten Rauschspektrums für ein zweites Frequenzband in der Frequenzanpassungsschaltung, wobei das erste Frequenzband und das zweite Frequenzband symmetrisch um die vorgegebene Frequenz angeordnet sind,
Vergleichen des ersten Rauschspektrums in dem ersten Frequenzband mit dem zweiten Rauschspektrum in dem zweiten Frequenzband (beispielsweise durch Vergleich der Signalleistungen), Erzeugen eines Anpassungssignals, das eine Frequenzanpassung der Resonanzfrequenz bewirkt, wenn das erste Rauschspektrum von dem zweiten Rauschspektrum unterschieden ist, und

Ausgeben des Anpassungssignals von der Frequenzanpassungsschaltung an einen Steuereingang des ersten Filters zum Anpassen der Resonanzfrequenz in Antwort auf das Vergleichsergebnis.

Weiterhin wird eine Signalverarbeitungsvorrichtung bereitgestellt, die eine geschlossene Regelschleife mit einem ersten Filter, das eine Resonanzfrequenz aufweist, und einem Delta-Sigma-Modulator und eine Frequenzanpassungsschaltung umfasst. Die Frequenzanpassungsschaltung ist dazu ausgebildet, ein Ausgangssignal des Delta-Sigma-Modulators (und somit der geschlossene Regelschleife) zu empfangen, ein erstes Rauschspektrum des Ausgangssignals des Delta-Sigma-Modulators für ein erstes Frequenzband und ein zweites Rauschspektrums des Ausgangssignals des Delta-Sigma-Modulators für ein zweites Frequenzband zu ermitteln, wobei das erste Frequenzband und das zweite Frequenzband symmetrisch um eine vorgegebene Frequenz angeordnet sind das erste Rauschspektrums in dem ersten Frequenzband mit dem zweiten Rauschspektrum in dem zweiten Frequenzband zu vergleichen, ein Anpassungssignals, das eine Frequenzanpassung der Resonanzfrequenz bewirkt, wenn das erste Rauschspektrum von dem zweiten Rauschspektrum unterschieden ist, zu erzeugen, und das Anpassungssignal an einen Steuereingang des ersten Filters zum Anpassen der Resonanzfrequenz an die vorgegeben Frequenz (insbesondere die Resonanzfrequenz eines weiteren Filters) in Antwort auf das Vergleichsergebnis auszugeben.

Vorteilhafte Weiterbildungen der vorliegenden Erfindung sind Gegenstand der Unteransprüche.

Zum besseren Verständnis der vorliegenden Erfindung wird diese anhand der in den nachfolgenden Figuren dargestellten Ausführungsbeispiele näher erläutert. Dabei werden gleiche Teile mit gleichen Bezugszeichen und gleichen Bauteilbezeichnungen versehen. Weiterhin können auch einzelne Merkmale oder Merkmalskombinationen aus den gezeigten und beschriebenen Ausführungsformen für sich genommen eigenständige erfinderische oder erfindungsgemäße Lösungen darstellen.

Es zeigen:

Fig. 1    eine schematische Darstellung eines Drehratensensors basierend auf dem Corioliseffekt;

Fig. 2    eine schematische Darstellung einer sekundären Regelschleife basierend auf dem Prinzip der Delta-Sigma-Modulation zum Betrieb eines Drehratensensors;

Fig. 3a    den Verlauf der spektralen Leistungsdichte des Ausgangs der sekundären Regelschleife bei Fehlanpassung zwischen einer primären Resonanzfrequenz eines Drehratensensors, einer sekundären Resonanzfrequenz des Drehratensensors und der Filterfrequenz des elektrischen Filters eines Delta-Sigma-Modulators;

Fig. 3b    den Verlauf der spektralen Leistungsdichte des Ausgangs der sekundären Regelschleife nach erfolgter optimaler Anpassung einer sekundären Resonanzfrequenz eines Drehratensensors und der Filterfrequenz eines elektrischen Filters eines Delta-Sigma-Modulators an eine primäre Resonanzfrequenz des Drehratensensors;

Fig. 4    den Verlauf der spektralen Leistungsdichte des Ausgangs der sekundären Regelschleife nach erfolgter optimaler Anpassung einer Filterfrequenz eines elektrischen Filters eines Delta-Sigma-Modulators an eine primäre Resonanzfrequenz des Drehratensensors und bei einer Fehlanpassung einer sekundären Resonanzfrequenz des Drehratensensors;

Fig. 5a    den Verlauf der spektralen Leistungsdichte des Ausgangs der sekundären Regelschleife nach erfolgter optimaler Anpassung einer sekundären Resonanzfrequenz eines Drehratensensors sowie die erfindungsgemäß zur Anpassung ins Basisband demodulierten Frequenzbänder;

Fig. 5b    den Verlauf der spektralen Leistungsdichte des Ausgangs der sekundären Regelschleife bei Fehlanpassung der anzupassenden sekundären Resonanzfrequenz eines Drehratensensors sowie die erfindungsgemäß zur Anpassung ins Basisband zu demodulierenden Frequenzbänder;

Fig. 6    eine schematische Darstellung eines Drehratensensors basierend auf dem Corioliseffekt mit einer Frequenzanpassungsschaltung gemäß einer beispielhaften Ausführungsform der vorliegenden Erfindung; und

Fig. 7    eine schematische Darstellung eines Drehratensensors basierend auf dem Corioliseffekt mit einer Frequenzanpassungsschaltung gemäß einer weiteren beispielhaften Ausführungsform der vorliegenden Erfindung.

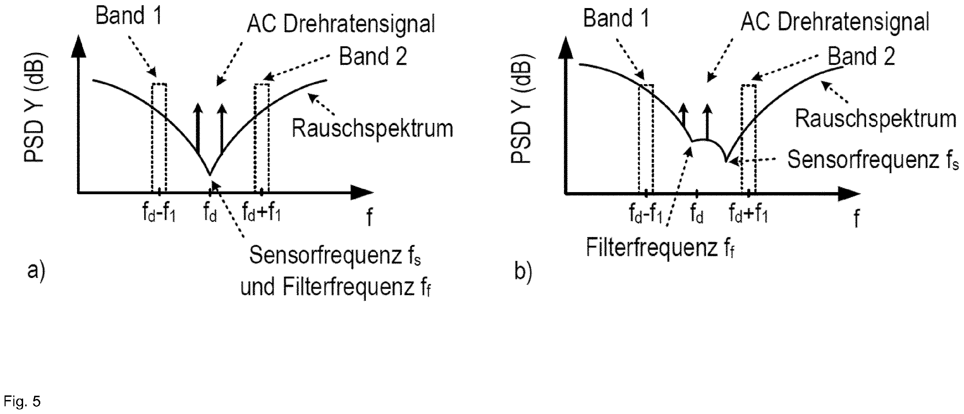

Mit Bezug auf die Figuren 5a, 5b, 6 und 7 werden nachfolgend Ausführungsformen der vorliegenden Erfindung nachfolgend näher beschrieben.

Das erfindungsgemäße Prinzip der Frequenzanpassung basiert dabei auf einer Bewertung der Rauschformung (Ermittlung des Rauschspektrums) einer geschlossenen sekundären Regelschleife am Ausgang Y eines $\Delta\Sigma M$ in einem differentiellen Band um die primäre Resonanzfrequenz $f_d$ (eines Filters oder mechanischen Resonators $H_p(s)$) herum, wobei symmetrisch zu der primären Resonanzfrequenz $f_d$ bestimmte Frequenzbänder einzeln ins Basisband demoduliert werden, um die Rausch- und Signalleistung in den beiden symmetrisch bestimmten Bändern miteinander vergleichen zu können. Dadurch lässt sich genau ermitteln, ob die aktuelle sekundäre Resonanzfrequenz $f_s$ verglichen mit der primären Resonanzfrequenz $f_d$ zu hoch oder zu niedrig ist, und es kann ein Signal zum Einstellen der sekundären Resonanzfrequenz $f_s$ generiert werden. Dieses Einstellsignal wird schließlich auf die sekundäre Masse m des Sensors rückgekoppelt, und es wird mittels des Spring-Softening Effekts die sekundäre Resonanzfrequenz $f_s$ eingestellt.

Wegen der differentiellen Betrachtungsweise im Frequenzbereich erfolgt durch ein vorhandenes Drehratensignal $F_C$ keine Störung des Einstellvorgangs. Aufgrund der zwei Seitenbänder des amplitudenmodulierten Drehratensignals $F_C$ tritt je eine Komponente gleichermaßen im $f_d + f_1$ beziehungsweise $f_d - f_1$ - Pfad auf. Zudem kann das Drehratensignal nach der Demodulation durch entsprechende Filter unterdrückt werden. Die Frequenzanpassung kann somit während des Betriebs im Hintergrund arbeiten, selbst wenn Teile eines Drehratensignals $F_C$ in einem der beiden symmetrisch zu der primären Resonanzfrequenz bestimmten Bändern auftreten.

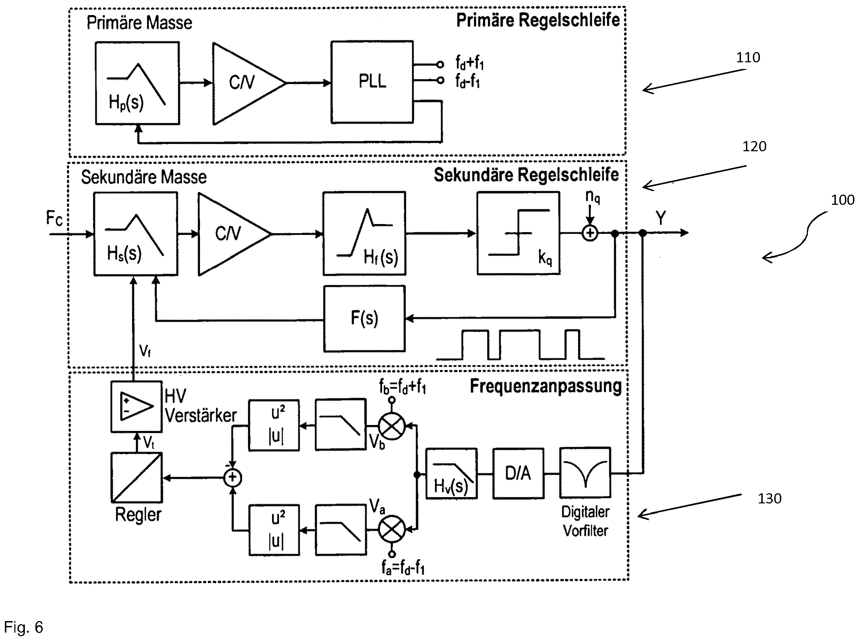

Die Figuren 5a und 5b zeigen beispielhaft den Verlauf der spektralen Leistungsdichte des Ausgangs Y des $\Delta\Sigma M$ und somit der sekundären Regelschleife in Abhängigkeit von der Frequenz f. Das Ausgangssignal genügt hierbei der oben beschriebenen Formel (3), wobei beispielsweise weißes Rauschen für das Quantisierungsrauschen $n_q$ angenommen werden kann. Figur 5a stellt den Fall erfolgter optimaler Anpassung $f_d = f_s = f_f$ schematisch dar, während Figur 5b ein Beispiel zeigt, in dem die sekundäre Resonanzfrequenz $f_s$ gegenüber der primären Resonanzfrequenz $f_d$ fehlangepasst ist ($f_d < f_s$ in dem gezeigten Beispiel). Erfindungsgemäß werden die Rausch- beziehungsweise Signalleistung in einem ersten Frequenzband (Band 1) und in einem zweiten Frequenzband (Band 2), die symmetrisch um die primäre Resonanzfrequenz $f_d$ mit einer vorbestimmten Bandbreite um $f_d + f_1$ beziehungsweise $f_d - f_1$ angeordnet sind, miteinander verglichen. Im Fall, dass $f_d = f_s = f_f$, verläuft die Kurve des Leistungsspektrums symmetrisch mit Bezug auf die Resonanzfrequenz $f_d$ der Primärschwingung und die Differenz der Werte für das Leistungsdichtespektrum von Band 1 und Band 2 verschwinden (siehe Figur 5a). Bildet man hingegen in dem in Figur 5b gezeigten ein Differenzsignal für die Bänder 1 und 2, so ist dieses ungleich Null und kann dazu verwendet werden, ein Anpassungssignal für den Eingang des Filters $H_s$ für die sekundäre Masse m erzeugen, wie es im Folgenden mit Bezug auf Figur 6 näher erläutert wird.

Figur 6 zeigt den grundlegenden Aufbau eines Drehratensensors 100 mit einer primären Regelschleife 110, einer sekundären Regelschleife 120 und einer Frequenzanpassungsschaltung 130 gemäß einer Ausführungsform der vorliegenden Erfindung. Von einer phasenverriegelten Regelschleife PLL (die einen Oszillator umfasst) der primären Regelschleife 110 können Signale mit Frequenzen $f_a = f_d + f_1$ und $f_b = f_d - f_1$ bereitgestellt werden, die also eine positive beziehungsweise negative Frequenzverschiebung bezüglich der primären Resonanzfrequenz $f_d$ aufweisen.

Wie es in Figur 6 gezeigt ist, wird ein Ausgangssignal Y der sekundären Regelschleife 120 in einen optionalen digitalen Vorfilter der Frequenzanpassungsschaltung 130 eingespeist und in ein Analogsignal gewandelt. Das Analogsignal wird in einem Filter $H_v(s)$ vorverstärkt und es werden in diesem Filter Frequenzen unterdrückt, die um mehr als eine vorbestimmte Schwelle oberhalb der primären Resonanzfrequenz $f_d$ liegen. Im nächsten Schritt wird das Signal mittels zweier Multiplizierer und den Frequenzen $f_a = f_d + f_1$ und $f_b = f_d - f_1$ demoduliert werden, um die resultierenden Basisbandsignale weiter auszuwerten. Durch die Multiplikation erscheinen somit Signale mit Frequenzen, die vorher um $f_1$ über bzw. unter $f_d$ lagen, anschließend bei 0 Hz (DC). Dies ermöglicht es, andere Signalkomponenten sehr einfach mit danach folgenden Tiefpassfiltern zu entfernen. Die Frequenzen $f_{a,b}$ können entweder mittels sinusförmigen Spannungen oder, um die Komplexität zu verringern, mittels Rechteckspannungen an die Multiplizierer angelegt werden.

Im nachfolgenden Schritt wird entweder die Leistung beziehungsweise Signalstärke beider Signale durch Quadrieren gemessen oder durch Absolutwertbildung angenähert, und es wird anschließend die Differenz der Leistungen beziehungsweise Signalstärken gebildet. Die Differenzgröße dient einem Regler, welcher vorteilhafterweise einen I-Anteil aufweist, als Fehlergröße. Der Regler kann dabei entweder kontinuierlich betrieben werden oder in Verbindungen mit einer Vorzeichenauswertung und einer digitalen Logik periodisch rückgesetzt werden. Der nach dem erstmaligen Einregeln erzielte Wert für die Stellgröße Vt kann vorteilhafterweise gespeichert werden, um bei einem nachfolgenden Start schneller die richtige Frequenz an die primäre Resonanzfrequenz $f_d$ angepasste sekundäre Resonanzfrequenz $f_s$ zu erreichen. Die Spannung $V_t$ wird schließlich als Stellgröße über einen Verstärker, welcher typischerweise im Hochspannungsbereich (Spannung größer als Standard-Versorgungsspannung des Chips) arbeitet, an die Elektroden zur Einstellung der sekundären Resonanzfrequenz $f_s$ des Sensors 100 zurückgekoppelt.

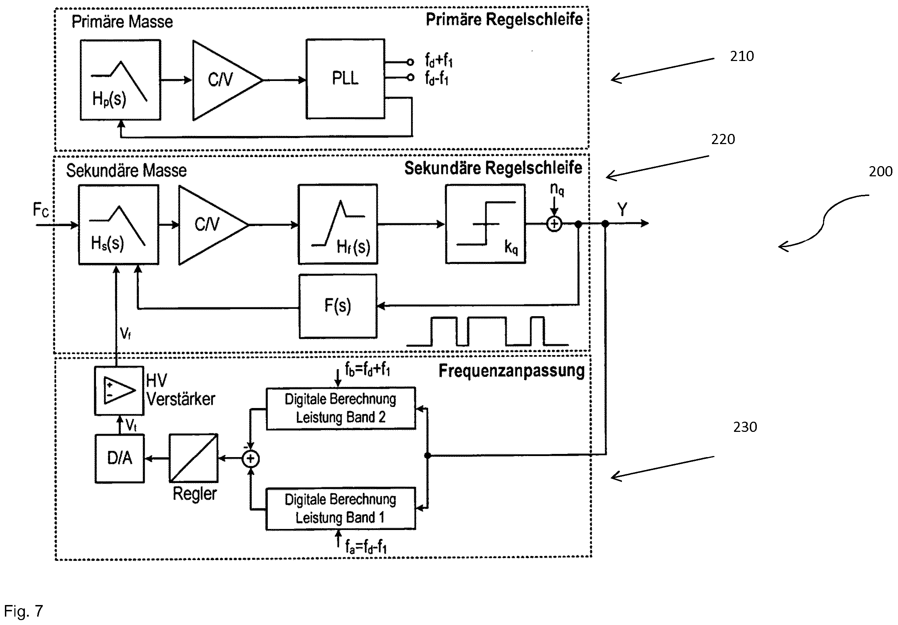

Während das erfindungsgemäße Verfahren in der in Figur 6 gezeigten Ausführungsform mit analoger Signalverarbeitung zur Frequenzanpassung erfolgt, zeigt Figur 7 eine Ausführungsform, in der eine Implementierung mit digitaler Signalverarbeitung zur Frequenzanpassung erfolgt. Auch der in Figur 7 gezeigt Drehratensensor 200 umfasst eine primären Regelschleife 210, eine sekundäre Regelschleife 220 und eine Frequenzanpassungsschaltung 230. Anders als in der in Figur 6 gezeigten Ausführungsform wird jedoch das Ausgangssignal Y der sekundären Regelschleife 220 zunächst nicht in der Frequenzanpassungsschaltung 230 in ein analoges Signal gewandelt, sondern es erfolgt die oben beschriebene Berechnung der Leistung beziehungsweise Signalstärke in den Bändern 1 und 2 und die Differenz derselben im digitalen Bereich. Wiederum dient die Differenz einem Regler als Fehlergröße und das von dem Regler entsprechend ausgegebene Signal dient nach Umwandlung in ein Analogsignal Vt und Verstärkung desselben als Stellgröße zur Einstellung der sekundären Resonanzfrequenz $f_s$ des Sensors 200. Die Ausführung der digitalen Signalverarbeitung kann äquivalent zur analogen Signalverarbeitung erfolgen, oder es können komplexere Methoden beispielsweise basierend auf dem Goertzel-Algorithmus, genutzt werden, um die Rauschleistung zu extrahieren.

Im Gegensatz zu den bekannten Lösungsansätzen des Stands der Technik stellt die vorliegende Erfindung einen Aufbau mit einem minimalen zusätzlichen Schaltungsaufwand und geringen Platzbedarf bereit. Des Weiteren wird durch die Einbeziehung eines großen Rauschsignalbandes eine deutlich schnellere und genauere Frequenzanpassung als bei einer Betrachtung diskreter Signalkomponenten im Spektrum des Ausgangs Y der sekundären Regelschleife erreicht. Da dazu keinerlei zusätzliche Signale in die sekundäre Regelschleife eingespeist werden müssen oder die sekundäre Regelschleife kurzzeitig getrennt werden muss, kann keine Beeinträchtigung der Funktionalität zur Signalauslese entstehen.

Wie bereits erwähnt ist der Anwendungsbereich der vorliegenden Erfindung nicht nur auf Drehratensensoren beschränkt. Die Erfindung findet zudem auch Anwendung im Betrieb anderer Sensoren, wie beispielsweise Beschleunigungssensoren, Lorentzkraft-Magnetfeldsensoren, usw. Des Weiteren kann insbesondere die Frequenzanpassung während des Betriebs auch bei Analog-Digital-Wandlern mit geschlossenen Regelschleifen (beispielsweise ΔΣM - ADC) zum Einsatz kommen. Das Konzept ist zudem bei jeglicher Art von Filtern anwendbar, bei der eine breitbandige Anregung des Filters erfolgt und somit anhand eines der Signale in der Anwendung die Transferfunktion des Filters näherungsweise abgebildet wird.

**Patentansprüche**

1.  Verfahren zur Anpassung der Resonanzfrequenz ($f_s$) eines ersten Filters ($H_s(s)$) einer geschlossenen Regelschleife (120, 220), die einen Delta-Sigma-Modulator umfasst, an eine vorgegebene Frequenz ($f_d$), wobei das Verfahren die folgenden Schritte aufweist:

    Zuführen eines Ausgangssignals (Y) des Delta-Sigma-Modulators in eine Frequenzanpassungsschaltung (130, 230);
    Ermitteln eines ersten Rauschspektrums des Ausgangssignals (Y) des Delta-Sigma-Modulators für ein erstes Frequenzband (Band 1) und eines zweiten Rauschspektrums des Ausgangssignals (Y) des Delta-Sigma-Modulators für ein zweites Frequenzband (Band 2) in der Frequenzanpassungsschaltung (130, 230), wobei das erste Frequenzband (Band 1) und das zweite Frequenzband (Band 2) symmetrisch um die vorgegebene Frequenz ($f_d$) angeordnet sind;
    Vergleichen des ersten Rauschspektrums in dem ersten Frequenzband (Band 1) mit dem zweiten Rauschspektrum in dem zweiten Frequenzband (Band 2);
    Erzeugen eines Anpassungssignals (Vt), das eine Frequenzanpassung der Resonanzfrequenz bewirkt, wenn das erste Rauschspektrum von dem zweiten Rauschspektrum unterschieden ist; und
    Ausgeben des Anpassungssignals ($V_t$) von der Frequenzanpassungsschaltung (130, 230) an einen Steuereingang des ersten Filters ($H_s(s)$) zum Anpassen der Resonanzfrequenz ($f_s$).

2.  Verfahren gemäß Anspruch 1, wobei zum Vergleichen des ersten Rauschspektrums mit dem zweiten Rauschspektrum das erste Frequenzband (Band 1) und das zweite Frequenzband (Band 2) jeweils einzeln in ein Basisband demoduliert werden und die Rauschleistung in dem ersten Frequenzband (Band 1) mit der Rauschleistung in dem zweiten Frequenzband (Band 2) oder die Signalstärke in dem ersten Frequenzband (Band 1) mit der Signalstärke in dem zweiten Frequenzband (Band 1) verglichen wird.

3.  Verfahren gemäß Anspruch 1 oder 2, in dem das erste Frequenzband (Band 1) mit einer vorbestimmten Breite um eine erste Frequenz ($f_d + f_1$) bestimmt wird und das zweite Frequenzband (Band 2) mit einer vorbestimmten Breite um eine zweite Frequenz ($f_d - f_1$) bestimmt wird, und wobei die erste Frequenz ($f_d + f_1$) und die zweite Frequenz ($f_d - f_1$) von einer weiteren Regelschleife (110, 210), insbesondere einer weiteren geschlossenen Regelschleife (110, 210), bereitgestellt werden, die ein zweites Filter oder einen mechanischen Resonator ($H_p(s)$) aufweist, das oder der die vorgegebene Frequenz ($f_d$) als weitere Resonanzfrequenz aufweist, und wobei das erste Filter ($H_s(s)$) eine Bewegung einer sekundären Masse und das zweite Filter oder der mechanische Resonator ($H_p(s)$) eine Bewegung einer primären Masse eines Drehratensensors darstellen.

4. Verfahren gemäß einem der vorhergehenden Ansprüche, in dem das erste und zweite Rauschspektrum in der Frequenzanpassungsschaltung (130, 230) im digitalen Bereich oder analogen Bereich ermittelt werden.

5. Signalverarbeitungsvorrichtung, die umfasst:

   eine geschlossene Regelschleife (120, 220) mit einem ersten Filter ($H_s(s)$), das eine Resonanzfrequenz ($f_s$) aufweist, und einem Delta-Sigma-Modulator; und
   eine Frequenzanpassungsschaltung (130, 230), die dazu ausgebildet ist,
   ein Ausgangssignal (Y) des Delta-Sigma-Modulators zu empfangen;
   ein erstes Rauschspektrum des Ausgangssignals (Y) des Delta-Sigma-Modulators für ein erstes Frequenzband (Band 1) und ein zweites Rauschspektrum des Ausgangssignals (Y) des Delta-Sigma-Modulators für ein zweites Frequenzband (Band 2) zu ermitteln, wobei das erste Frequenzband (Band 1) und das zweite Frequenzband (Band 2) symmetrisch um eine vorgegebene Frequenz ($f_d$) angeordnet sind;
   das erste Rauschspektrums in dem ersten Frequenzband (Band 1) mit dem zweiten Rauschspektrum in dem zweiten Frequenzband (Band 2) zu vergleichen;
   ein Anpassungssignals ($V_t$), das eine Frequenzanpassung der Resonanzfrequenz ($f_s$) bewirkt, wenn das erste Rauschspektrum von dem zweiten Rauschspektrum unterschieden ist, zu erzeugen; und
   das Anpassungssignal ($V_t$) an einen Steuereingang des ersten Filters ($H_s(s)$) zum Anpassen der Resonanzfrequenz ($f_s$) an die vorgegebene Frequenz ($f_d$) in Antwort auf das Vergleichsergebnis auszugeben.

6. Signalverarbeitungseinrichtung gemäß Anspruch 5, in der

   die Frequenzanpassungsschaltung (130, 230) einen ersten und einen zweiten Demodulatorzweig aufweist, die betrieben werden, um das erste Rauschspektrum in dem ersten Frequenzband und das zweite Rauschspektrum in dem zweiten Frequenzband zu ermitteln, und wobei
   der erste Demodulatorzweig einen ersten Multiplizierer aufweist, der betrieben wird, um das Ausgangssignals (Y) des Delta-Sigma-Modulators mit einer ersten Vergleichsfrequenz ($f_d + f_1$) zu multiplizieren, die höher als die vorgegebene Frequenz ($f_d$) ist, und wobei
   der zweite Demodulatorzweig einen zweiten Multiplizierer aufweist, der betrieben wird, um das Ausgangssignals (Y) des Delta-Sigma-Modulators mit einer zweiten Vergleichsfrequenz ($f_d - f_1$) zu multiplizieren, die niedriger als die vorgegebene Frequenz ($f_d$) ist, und wobei
   der die erste und die zweite Vergleichsfrequenz symmetrisch zu der vorgegebenen Frequenz ($f_d$) angeordnet sind.

7. Signalverarbeitungseinrichtung gemäß Anspruch 6, wobei die Frequenzanpassungsschaltung (130, 230) einen Addierer umfasst und jeder der Demodulatorzweige jeweils einen Quadrierer aufweist und die Ausgänge der Quadrierer mit dem Addierer verbunden sind, der dazu ausgebildet ist, eine Differenz der an den Ausgängen der Quadrierer anliegenden Signale zu bestimmen und einen Differenzwert auszugeben.

8. Signalverarbeitungseinrichtung gemäß Anspruch 6, wobei die Frequenzanpassungsschaltung (130, 230) einen Addierer umfasst und wobei jeder der Demodulatorzweige jeweils ein Absolutwertelement zum Bestimmen eines Absolutwertes aufweist und die Ausgänge der Absolutwertelemente mit dem Addierer verbunden sind, der dazu ausgebildet ist, eine Differenz der an den Ausgängen der Absolutwertelemente anliegenden Signale zu bestimmen und einen Differenzwert auszugeben.

9. Signalverarbeitungseinrichtung gemäß einem der Ansprüche 7 und 8, weiterhin eine Regeleinheit umfassend, die mit dem Addierer verbunden ist und dazu ausgebildet ist, aus dem Differenzwert das Anpassungssignal zu erzeugen.

10. Signalverarbeitungseinrichtung gemäß einem der Ansprüche 5 bis 9, weiterhin eine weitere Regelschleife (110, 210), insbesondere eine weitere geschlossene Regelschleife (110, 210), umfassend, die ein zweites Filter oder einen mechanischen Resonator ($H_p(s)$) aufweist, das oder der die vorgegebene Frequenz ($f_d$) als weitere Resonanzfrequenz aufweist.

11. Signalverarbeitungseinrichtung gemäß Anspruch 10, in der die weitere geschlossene Regelschleife (110, 210) eine phasenverriegelte Regelschleife (PLL) umfasst, die dazu ausgebildet ist, die erste Vergleichsfrequenz ($f_d + f_1$) und die zweite Vergleichsfrequenz ($f_d - f_1$) bereitzustellen.

12. Signalverarbeitungseinrichtung gemäß einem der Ansprüche 5 bis 11, in der die Frequenzanpassungsschaltung (130, 230) dazu ausgebildet ist, das erste Rauschspektrum und das zweite Rauschspektrum im digitalen oder analogen Bereich zu ermitteln und miteinander zu vergleichen.

13. Schaltungsanordnung zum Auslesen eines kapazitiven Drehratensensors mit mindestens einer primären Masse und mindestens einer sekundären Masse, die mit der primären Masse verbunden ist, wobei die primäre Masse im Betrieb zu einer Primärschwingung angeregt wird, und wobei die sekundäre Masse in einer Richtung quer zur Primärschwingung aus einer Ruhelage ausgelenkt wird, wenn der Drehratensensor um eine sensitive Achse, die quer zu der Richtung der Primärschwingung und zu der Richtung der Auslenkung der sekundären Masse verläuft, rotiert, wobei die Schaltungsanordnung aufweist:

eine Signalverarbeitungseinrichtung gemäß einem der Ansprüche 5 bis 12, wobei die vorgegebene Frequenz ($f_d$) die Frequenz der Primärschwingung ist, und
eine Steuereinheit, die dazu ausgebildet ist, ein Drehratensignal basierend auf dem Ausgangssignal (Y) des Delta-Sigma-Modulators zu berechnen und auszugeben.

14. Coriolisdrehratensensor mit mindestens einer primären Masse und mindestens einer sekundären Masse, die mit der primären Masse verbunden ist, wobei die primäre Masse im Betrieb zu einer Primärschwingung angeregt wird, und wobei die sekundäre Masse in einer Richtung quer zur Primärschwingung ausgelenkt wird, wenn der Coriolisdrehratensensor um eine sensitive Achse rotiert,
wobei der Coriolisdrehratensensor zum Auslesen eines Drehratensignals eine Schaltungsanordnung nach Anspruch 13 aufweist.


**Claims**

1. Method for adapting the resonant frequency ($f_s$) of a first filter ($H_s(s)$) of a closed control loop (120, 220) having a delta-sigma modulator to a predetermined frequency ($f_d$), the method comprising the following steps:

feeding an output signal (Y) of the delta-sigma modulator into a frequency adaptation circuit (130, 230);
determining a first noise spectrum of the output signal (Y) of the delta-sigma modulator for a first frequency band (Band 1) and a second noise spectrum of the output signal (Y) of the delta-sigma modulator for a second frequency band (Band 2) in the frequency adaptation circuit (130, 230), wherein the first frequency band (Band 1) and the second frequency band (Band 2) are arranged symmetrically with respect to the predetermined frequency ($f_d$);
comparing the first noise spectrum in the first frequency band (Band 1) with the second noise spectrum in the second frequency band (Band 2);
generating an adaptation signal ($V_t$) that causes a frequency adaptation of the resonant frequency if the first noise spectrum differs from the second noise spectrum; and
outputting the adaptation signal ($V_t$) from the frequency adaptation circuit (130, 230) to a control input of the first filter ($H_s(s)$) for adapting the resonant frequency ($f_s$).

2. Method according to claim 1, wherein, to compare the first noise spectrum with the second noise spectrum, the first frequency band (Band 1) and the second frequency band (Band 2) are each demodulated individually into a baseband and the noise power in the first frequency band (Band 1) is compared with the noise power in the second frequency band (Band 2) or the signal strength in the first frequency band (Band 1) is compared with the signal strength in the second frequency band (Band 1).

3. Method according to either claim 1 or claim 2, wherein

the first frequency band (Band 1) with a predetermined width is determined with respect to a first frequency ($f_d + f_1$) and the second frequency band (Band 2) with a predetermined width is determined with respect to a second frequency ($f_d - f_1$), and wherein
the first frequency ($f_d + f_1$) and the second frequency ($f_d - f_1$) are provided by a further control loop (110, 210), in particular a further closed control loop (110, 210), having a second filter or a mechanical resonator ($H_p(s)$) which has the predetermined frequency ($f_d$) as a further resonant frequency, and wherein the first filter ($H_s(s)$) represents a movement of a secondary mass and the second filter or the mechanical resonator ($H_p(s)$) represents a movement of a primary mass of a rotation rate sensor.

4. Method according to any of the preceding claims, wherein the first and second noise spectrum in the frequency adaptation circuit (130, 230) are determined in the digital domain or in the analogue domain.

5. Signal processing device comprising:

a closed control loop (120, 220) having a first filter ($H_s$(s)), which has a resonant frequency ($f_s$), and a delta-sigma modulator; and
a frequency adaptation circuit (130, 230) which is designed
to receive an output signal (Y) of the delta-sigma modulator;
to determine a first noise spectrum of the output signal (Y) of the delta-sigma modulator for a first frequency band (Band 1) and a second noise spectrum of the output signal (Y) of the delta-sigma modulator for a second frequency band (Band 2),
wherein the first frequency band (Band 1) and the second frequency band (Band 2) are arranged symmetrically with respect to a predetermined frequency ($f_d$);
to compare the first noise spectrum in the first frequency band (Band 1) with the second noise spectrum in the second frequency band (Band 2);
to generate an adaptation signal ($V_t$) that causes a frequency adaptation of the resonant frequency ($f_s$) if the first noise spectrum differs from the second noise spectrum; and
to output the adaptation signal ($V_t$) to a control input of the first filter ($H_s$(s)) for adapting the resonant frequency ($f_s$) to the predetermined frequency ($f_d$) in response to the comparison result.

6. Signal processing device according to claim 5, wherein

the frequency adaptation circuit (130, 230) has a first and a second demodulator branch which are operated to determine the first noise spectrum in the first frequency band and the second noise spectrum in the second frequency band, and wherein
the first demodulator path comprises a first multiplier which is operated to multiply the output signal (Y) of the delta-sigma modulator with a first comparison frequency ($f_d + f_1$) which is higher than the predetermined frequency ($f_d$), and wherein
the second demodulator path comprises a second multiplier which is operated to multiply the output signal (Y) of the delta-sigma modulator with a second comparison frequency ($f_d - f_1$) which is lower than the predetermined frequency ($f_d$), and wherein
the first and the second comparison frequency are arranged symmetrically in relation to the predetermined frequency ($f_d$).

7. Signal processing device according to claim 6, wherein the frequency adaptation circuit (130, 230) comprises an adder and each of the demodulator branches each has a squarer and the outputs of the squarers are connected to the adder, which is designed to determine a difference between the signals applied to the outputs of the squarers and to output a differential value.

8. Signal processing device according to claim 6, wherein the frequency adaptation circuit (130, 230) comprises an adder and wherein each of the demodulator branches each have an absolute value element for determining an absolute value and the outputs of the absolute value elements are connected to the adder, which is designed to calculate a difference between the To determine the signals present at the outputs of the absolute value elements and to output a differential value.

9. Signal processing device according to either claim 7 or claim 8, further comprising a control unit which is connected to the adder and is designed to generate the adaptation signal from the differential value.

10. Signal processing device according to any of claims 5 to 9, further comprising a further control loop (110, 210), in particular a further closed control loop (110, 210), which has a second filter or a mechanical resonator ($H_p$(s)), which filter or resonator has the predetermined frequency ($f_d$) as a further resonant frequency.

11. Signal processing device according to claim 10, wherein the further closed control loop (110, 210) comprises a phase-locked control loop (PLL) which is designed to provide the first comparison frequency ($f_d + f_1$) and the second comparison frequency ($f_d - f_1$).

12. Signal processing device according to any of claims 5 to 11, wherein the frequency adaptation circuit (130, 230) is designed to determine the first noise spectrum and the second noise spectrum in the digital domain or analogue domain and to compare them with one another.

13. Circuit arrangement for reading a capacitive rotation rate sensor having at least one primary mass and at least one secondary mass connected to the primary mass, wherein the primary mass is excited to a primary oscillation during operation, and wherein the secondary mass is deflected in a direction transverse to the primary oscillation if the rotation rate sensor rotates about a sensitive axis which extends transversely to the direction of the primary oscillation and to the direction of the deflection of the secondary mass, wherein the circuit arrangement comprises:

a signal processing device according to any of claims 5 to 12, wherein the predetermined frequency ($f_d$) is the frequency of the primary oscillation, and
a control unit which is designed to calculate a rotation rate signal based on the output signal (Y) of the delta-sigma modulator and to output said signal.

14. Coriolis rotation rate sensor having at least one primary mass and at least one secondary mass connected to the primary mass, wherein the primary mass is excited to a primary oscillation during operation, and wherein the secondary mass is deflected in a direction transverse to the primary oscillation if the Coriolis rotation rate sensor rotates about a sensitive axis,
wherein the Coriolis rotation rate sensor comprises a circuit arrangement according to claim 13 for reading a rotation rate signal.

**Revendications**

1. Procédé permettant d'adapter à une fréquence prédéfinie ($f_d$) la fréquence de résonance ($f_s$) d'un premier filtre ($H_s(s)$) d'une boucle de régulation fermée (120, 220) comprenant un modulateur delta-sigma, dans lequel le procédé comprend les étapes ci-dessous consistant à :

acheminer un signal de sortie (Y) du modulateur delta-sigma dans un circuit d'adaptation de fréquence (130, 230) ;
déterminer, au sein du circuit d'adaptation de fréquence (130, 230), un premier spectre de bruit du signal de sortie (Y) du modulateur delta-sigma pour une première bande de fréquence (bande 1) et un second spectre de bruit du signal de sortie (Y) du modulateur delta-sigma pour une seconde bande de fréquence (bande 2), dans lequel la première bande de fréquence (bande 1) et la seconde bande de fréquence (bande 2) sont agencées de manière symétrique par rapport à la fréquence prédéfinie ($f_d$) ;
comparer le premier spectre de bruit dans la première bande de fréquence (bande 1) au second spectre de bruit dans la seconde bande de fréquence (bande 2) ;
générer un signal d'adaptation ($V_t$) qui provoque une adaptation de fréquence de la fréquence de résonance lorsque le premier spectre de bruit est différent du second spectre de bruit ; et
fournir le signal d'adaptation ($V_t$) à une entrée de commande du premier filtre ($H_s(s)$) grâce au circuit d'adaptation de fréquence (130, 230) afin d'adapter la fréquence de résonance ($f_s$).

2. Procédé selon la revendication 1, dans lequel, afin de comparer le premier spectre de bruit au second spectre de bruit, la première bande de fréquence (bande 1) et la seconde bande de fréquence (bande 2) sont respectivement démodulées de manière individuelle en une bande de base et la puissance de bruit dans la première bande de fréquence (bande 1) est comparée à la puissance de bruit dans la seconde bande de fréquence (bande 2) ou l'intensité de signal dans la première bande de fréquence (bande 1) est comparée à l'intensité de signal dans la seconde bande de fréquence (bande 1).

3. Procédé selon la revendication 1 ou 2, dans lequel la première bande de fréquence (bande 1) est définie avec une largeur prédéfinie par rapport à une première fréquence ($f_d + f_1$) et la seconde bande de fréquence (bande 2) est définie avec une largeur prédéfinie par rapport à une seconde fréquence ($f_d - f_1$), et dans lequel la première fréquence ($f_d + f_1$) et la seconde fréquence ($f_d - f_1$) sont fournies par une autre boucle de régulation (110, 210), en particulier par une autre boucle de régulation fermée (110, 210), qui présente un second filtre, ou un résonateur mécanique ($H_p(s)$), présentant la fréquence prédéfinie ($f_d$) en tant que fréquence de résonance supplémentaire, et dans lequel le premier filtre ($H_s(s)$) représente un mouvement d'une masse secondaire et le second filtre ou le résonateur mécanique ($H_p(s)$) représente un mouvement d'une masse primaire d'un capteur de vitesse de rotation.

4. Procédé selon l'une quelconque des revendications précédentes, dans lequel les premier et second spectres de bruit sont déterminés au sein du circuit d'adaptation de fréquence (130, 230) dans le domaine numérique ou dans le domaine analogique.

5. Dispositif de traitement de signal, comprenant :

une boucle de régulation fermée (120, 220), avec un premier filtre ($H_s(s)$), présentant une fréquence de résonance ($f_s$), et un modulateur delta-sigma ; et
un circuit d'adaptation de fréquence (130, 230) configuré pour
recevoir un signal de sortie (Y) du modulateur delta-sigma ;
déterminer un premier spectre de bruit du signal de sortie (Y) du modulateur delta-sigma pour une première bande de fréquence (bande 1) et un second spectre de bruit du signal de sortie (Y) du modulateur delta-sigma pour une seconde bande de fréquence (bande 2), dans lequel la première bande de fréquence (bande 1) et la seconde bande de fréquence (bande 2) sont agencées de manière symétrique par rapport à une fréquence prédéfinie ($f_d$) ;
comparer le premier spectre de bruit dans la première bande de fréquence (bande 1) au second spectre de bruit dans la seconde bande de fréquence (bande 2) ;
générer un signal d'adaptation ($V_t$) qui provoque une adaptation de fréquence de la fréquence de résonance ($f_s$) lorsque le premier spectre de bruit est différent du second spectre de bruit ; et
fournir le signal d'adaptation ($V_t$) à une entrée de commande du premier filtre ($H_s(s)$) afin d'adapter la fréquence de résonance ($f_s$) à la fréquence prédéfinie ($f_d$) en réponse au résultat de la comparaison.

6. Dispositif de traitement de signal selon la revendication 5, au sein duquel

le circuit d'adaptation de fréquence (130, 230) présente des première et seconde branches de démodulateur qui sont utilisées pour déterminer le premier spectre de bruit dans la première bande de fréquence et le second spectre de bruit dans la seconde bande de fréquence, et dans lequel
la première branche de démodulateur présente un premier multiplicateur qui est utilisé pour multiplier le signal de sortie (Y) du modulateur delta-sigma par une première fréquence de comparaison ($f_d + f_1$) qui est supérieure à la fréquence prédéfinie ($f_d$), et dans lequel
la seconde branche de démodulateur présente un second multiplicateur qui est utilisé pour multiplier le signal de sortie (Y) du modulateur delta-sigma par une seconde fréquence de comparaison ($f_d - f_1$) qui est inférieure à la fréquence prédéfinie ($f_d$), et dans lequel
les première et seconde fréquences de comparaison sont agencées de manière symétrique par rapport à la fréquence prédéfinie ($f_d$).

7. Dispositif de traitement de signal selon la revendication 6, dans lequel
le circuit d'adaptation de fréquence (130, 230) comprend un additionneur et chacune des branches de démodulateur présente respectivement un dispositif d'élévation au carré et les sorties des dispositifs d'élévation au carré sont reliées à l'additionneur, qui est configuré pour définir une différence entre les signaux présents au niveau des sorties des dispositifs d'élévation au carré et pour fournir une valeur de différence.

8. Dispositif de traitement de signal selon la revendication 6, dans lequel
le circuit d'adaptation de fréquence (130, 230) comprend un additionneur et dans lequel chacune des branches de démodulateur présente respectivement un élément de valeur absolue permettant de définir une valeur absolue et les sorties des éléments de valeur absolue sont reliées à l'additionneur, qui est configuré pour définir une différence entre les signaux présents au niveau des sorties des éléments de valeur absolue et pour fournir une valeur de différence.

9. Dispositif de traitement de signal selon la revendication 7 ou 8, comprenant en outre une unité de régulation qui est reliée à l'additionneur et est configurée pour générer le signal d'adaptation à partir de la valeur de différence.

10. Dispositif de traitement de signal selon l'une quelconque des revendications 5 à 9, comprenant en outre une boucle de régulation (110, 210) supplémentaire, en particulier une boucle de régulation fermée (110, 210) supplémentaire, qui présente un second filtre, ou un résonateur mécanique ($H_p(s)$), présentant la fréquence prédéfinie ($f_d$) en tant que fréquence de résonance supplémentaire.

11. Dispositif de traitement de signal selon la revendication 10, dans lequel la boucle de régulation fermée (110, 210) supplémentaire comprend une boucle de régulation à verrouillage de phase (PLL) configurée pour fournir la première fréquence de comparaison ($f_d + f_1$) et la seconde fréquence de comparaison ($f_d - f_1$).

12. Dispositif de traitement de signal selon l'une quelconque des revendications 5 à 11, dans lequel le circuit d'adaptation de fréquence (130, 230) est configuré pour déterminer le premier spectre de bruit et le second spectre de bruit dans le domaine numérique ou analogique et pour les comparer entre eux.

13. Agencement de circuit permettant de lire un capteur de vitesse de rotation capacitif comprenant au moins une masse primaire et au moins une masse secondaire reliée à la masse primaire, dans lequel, en cours d'utilisation, la masse primaire est excitée pour fournir une oscillation primaire, et dans lequel, à partir d'une position de repos, la masse secondaire est déviée dans une direction transversale par rapport à l'oscillation primaire lorsque le capteur de vitesse de rotation tourne autour d'un axe sensible s'étendant de manière transversale par rapport à la direction de l'oscillation primaire et par rapport à la direction de la déviation de la masse secondaire, dans lequel l'agencement de circuit présente :

un dispositif de traitement de signal selon l'une quelconque des revendications 5 à 12, dans lequel la fréquence prédéfinie ($f_d$) est la fréquence de l'oscillation primaire, et
une unité de commande configurée pour calculer et fournir un signal de vitesse de rotation en se basant sur le signal de sortie (Y) du modulateur delta-sigma.

14. Capteur de vitesse de rotation de Coriolis comprenant au moins une masse primaire et au moins une masse secondaire reliée à la masse primaire, dans lequel, en cours d'utilisation, la masse primaire est excitée pour fournir une oscillation primaire, et dans lequel la masse secondaire est déviée dans une direction transversale par rapport à l'oscillation primaire lorsque le capteur de vitesse de rotation de Coriolis tourne autour d'un axe sensible,
dans lequel le capteur de vitesse de rotation de Coriolis présente un agencement de circuit selon la revendication 13 afin de lire un signal de vitesse de rotation.

**Primäre Regelschleife**

$H_p(s)$

Elektronik

$H_s(s)$

Elektronik

**Sekundäre Regelschleife**

Fig. 1

Sekundäre Regelschleife

Elektrisches Filter

Sekundäre Masse

$F_C$

$H_s(s)$

$C/V$

$V_{filt}$

$H_f(s)$

$F(s)$

$k_q$

$n_q$

$Y$

Fig. 2

15

Fig. 3

Drehratensignal bei $f_d$

Rauschspektrum

Resonanzfrequenz
elektrisches Filter $f_f$

Resonanzfrequenz
sekundäre Masse $f_s$

PSD Y (dB)

$f_d$

$f$

Fig. 4

Fig. 5

Fig. 6

Fig. 7

EP 3 653 991 B1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102016204683
- DE 19910415 A1
- US 20180128674 A1
- EP 2466257 A1

**In der Beschreibung aufgeführte Nicht-Patentliteratur**

- **T. NORTHEMANN ; M. MAURER ; S. ROMBACH ; A. BUHMANN ; Y. MANOLI.** Drive and sense interface for gyroscopes based on bandpass sigma-delta modulators. *Proc. IEEE Int. Circuits and Systems (IS-CAS) Symp,* 2010, 3264-3267
- **A. SHARMA ; M. F. ZAMAN ; F. AYAZI.** A sub-0.2°/hr bias drift micromechanical silicon gyroscope with automatic CMOS modematching. *IEEE J. Solid-State Circuits,* Mai 2009, vol. 44 (5), 1593-1608
- **S. SONMEZOGLU ; S. E. ALPER ; T. AKIN.** An Automatically Mode-Matched MEMS Gyroscope With Wide and Tunable Bandwidth. *Journal of Microelectromechanical Systems,* April 2014, vol. 23 (2), 284-297
- **S. SUNG ; W. T. SUNG ; C. KIM ; S. YUN ; Y. J. LEE.** On the Mode-Matched Control of MEMS Vibratory Gyroscope via Phase-Domain Analysis and Design. *IEEE/ASME Transactions on Mechatronics,* August 2009, vol. 14 (4), 446-455
- **C. HE et al.** A MEMS Vibratory Gyroscope With Real-Time Mode-Matching and Robust Control for the Sense Mode. *IEEE Sensors Journal,* April 2015, vol. 15 (4), 2069-2077
- **HUANZHANG HUANG ; LEE, E.K.F.** Frequency and Q tuning techniques for continuoustime bandpass sigma-delta modulator. *ISCAS 2002. IEEE International Symposium on Circuits and Systems,* 2002, vol. 5, V-589-V-592
- **YUN-SHIANG SHU ; BANG-SUP SONG ; BACRANIA, K.** A 65nm CMOS CT ΔΣ Modulator with 81 dB DR and 8MHz BW Auto-Tuned by Pulse Injection. *Solid-State Circuits Conference, 2008. ISSCC 2008. Digest of Technical Papers, IEEE International,* 03. Februar 2008, 500-631
- **MICHAEL MAURER ; STEFAN ROMBACH ; YIANNOS MANOLI.** Resonance Frequency Control and Digital Correction for Capacitive MEMS Gyroscopes within electromechanical Bandpass Delta-Sigma-Modulators. *2018 IEEE International Symposium on Inertial Sensors and Systems (INERTIAL),* 61-64